# EUROPEAN PATENT SPECIFICATION

(11) **EP 0 915 509 B1**
(45) Date of publication and mention of the grant of the patent: **28.12.2005**
(21) Application number: 97830543.1
(22) Date of filing: 24.10.1997
(51) Int. Cl.: H01L 21/8234, H01L 27/088, H01L 29/10

(54) **Process for integrating, in a same semiconductor chip, MOS technology devices with different threshold voltages**
Verfahren zur Integration von MOS-Technologie-Bauelementen mit unterschiedlichen Schwellenspannungen in demselben Halbleiterchip
Procédé d'intégration -dans le même puce semi-conductrice- de dispositifs semi-conducteurs comportant des tensions de seuil différentes

(43) Date of publication of application: 12.05.1999
(73) Proprietor: STMicroelectronics S.r.l., 20041 Agrate Brianza (Milano) (IT)
(72) Inventor: Frisina, Ferruccio, 95030 Sant'Agata Li Battiati (Catania) (IT); Bolognesi, Davide, 44011 Argenta (Ferrara) (IT); Magri', Angelo, 95032 Belpasso (Catania) (IT)
(74) Representative: Mittler, Enrico

(56) References cited:
- EP-A- 0 452 817
- EP-A- 0 772 242
- EP-A- 0 791 965
- US-A- 4 941 027
- US-A- 5 635 742

## Description

The present invention refers to a process for integrating, in a same semiconductor chip, MOS technology devices with different threshold voltages, particularly MOS transistors with vertical and/or horizontal current flux.

Known solutions for integrating in a same semiconductor chip MOS devices with different threshold voltages provides for varying the thickness of the gate oxides, or the dopant concentrations in the channel regions of the MOS transistors.

For example, if horizontal MOS transistors with different threshold voltages have to be integrated in the same chip, it is necessary to perform as many selective dopant implantations as the different values of the threshold voltages to be obtained, each implantation having a respective dopant dose and involving only the channel regions of those MOS transistors having a same threshold voltage.

Alternatively, the horizontal MOS transistors can be formed inside respective doped semiconductor wells, each having a different dopant concentration, which are formed in a common semiconductor substrate.

If instead of acting on the dopant concentrations in the channel regions one acts on the thickness of the gate oxides, as many steps of growth and selective removal of oxide layers are necessary as the different values of the threshold voltages to be obtained.

Similar considerations are valid also for vertical MOS transistors. The known processes for the fabrication of vertical MOS transistors provides for the formation, on a lightly doped drain layer for example of N type of a gate electrode, and the selective introduction in the drain layer of a dopant (of P type in this example) using the gate electrode as a mask for the formation of the so-called body regions of the transistor; such body regions extend under the gate electrode to form a channel region of the transistor. In order to integrate in a same chip vertical MOS transistors with different threshold voltages, it is necessary to perform, for each transistor, a dedicated dopant implantation so as to form body regions with different dopant concentrations or, if one wishes to act on the thickness of the gate oxides, to provide as many steps of growth and selective removal of oxide layers as the different values of the threshold voltage to be obtained.

This obviously makes the manufacturing processes longer, more complex and thus more costly.

EP 791965 discloses a DMOS power transistor with four terminals.

US 4941027 discloses a high voltage MOS structure wherein the threshold of a double diffused insulated gate transistor is determined by selectively positioning the source in the decreasing impurity concentration region of the body to set the peak impurity concentration in the channel region for the desired threshold voltage without modification of the process.

US 5635742 discloses a lateral double-diffused MOSFET having a semiconductor substrate, a drain region formed on the substrate, a gate insulation film formed on the drain region, a gate electrode formed on the gate insulation film, source and drain openings formed through the gate electrode, a first conductive region formed under the drain region, a source electrode formed on the source openings, a drain electrode formed on the drain openings and second conductive regions for connecting the drain electrode to the first conductive region.

EP 452817 discloses a semiconductor device having a well formed in a semiconductor substrate by using a mask in which a mask pattern width of a portion corresponding to an opening diameter is equal to or less than twice the diffusion depth of the well layer, and a gate electrode formed to have the well layer as a channel region of a MOS transistor. The well formed in this manner has a substantially semi-circular section to facilitate impurity concentration control in the substrate surface. When a plurality of types of opening patterns having small pattern widths are formed in a single mask, MOS transistors having different threshold voltages can be formed in a single process.

EP 772242 discloses a single feature size MOS technology power device.

In view of the state of the art described, it is an object of the present invention to provide a process for the integration in a same semiconductor chip of MOS devices having different threshold voltages, such a process not requiring as far as possible additional manufacturing steps with respect to the known processes for the fabrication of MOS devices.

According to the present invention, such an object is achieved by means of a process for integrating in a same MOS technology devices with different threshold voltages, characterized by comprising the steps of:
a) simultaneously forming on a semiconductor material layer of at least two gate electrodes for at least two MOS devices, said gate electrodes comprising substantially rectilinear portions and corners, each gate electrode having a respective corner density per unit area;
b) selectively introducing in the semiconductor material layer a dopant for the simultaneous formation of respective channel regions for said at least two MOS devices, said channel regions extending under the respective gate electrode, said selective introduction using as a mask the respective gate electrodes so that said channel regions have, at the corners of the respective gate electrode, a dopant concentration lower than that at the substantially rectilinear portions, and said two MOS devices consequently have respective threshold voltages that depend on the corner density per unit area and on the
aperture angles of the corners of the respective gate electrodes, the step b) beine performed subsequently to the step a).

Thanks to the present invention, it is possible to integrate simply and economically in a same semiconductor chip MOS devices having different threshold voltages. In the case that at least one of the MOS devices to be integrated in the chip is a MOS transistor with vertical current flux, the process according to the invention does not require any additional process step with respect to the known processes: in fact, step b) of the process that provides for selectively introducing dopant for the formation of the channel region coincides with the step normally provided for the formation of the body region of the MOS transistors in the drain layer; the threshold voltage of the MOS transistors can thus be adjusted acting only on the geometry of the gate electrode, i.e. on the density of corners for unit area and/or on the aperture angle of the corners.

If together with the vertical MOS transistor(s) one or more horizontal MOS transistors are to be integrated, in addition to the formation of a well of conductivity type opposite to the drain layer, as in the conventional processes, the process according to the invention provides, compared to the known manufacturing processes, a step of selective introduction of dopant using as a mask the gate electrode; however, since this step is already provided for the formation of the vertical MOS transistor(s), also in this case the process according to the invention does not require any additional manufacturing step, but only the definition of the gate electrodes with a suitable geometry.

Finally, if the MOS devices to be integrated in the same chip are only horizontal MOS transistors, the process according to the invention allows, by means of the addition of only one step with respect to the conventional processes for the manufacturing of MOS devices (i.e., the step of implanting dopant in a self-aligned way to the gate electrodes), to obtain as many threshold voltage values as desired, acting on the geometry of the gate electrodes of the different MOS transistors.

The features and advantages of the present invention will be made apparent by the following detailed description of two practical embodiments thereof, illustrated as non-limiting examples in the annexed drawings, wherein:
Figure 1 is a schematic top-plan view of a semiconductor chip wherein two vertical MOS transistors are integrated having different threshold voltages;
Figure 2 shows a first step of a manufacturing process according to the invention for the integration in a same semiconductor chip of at least two vertical MOS transistors with different threshold voltages;
Figure 3 is a top-plan view of two portions of a semiconductor chip wherein there are respectively integrated two vertical MOS transistors with different threshold voltages;
Figures 4 and 5 shows two further steps of the process according to the invention;
Figure 6 is an enlarged top-plan view of a cell of the vertical MOS transistor, wherein there are shown lines of equal dopant concentration in the channel region of the transistor;
Figure 7 shows the surface doping profiles along directions a and b in Figure 6;
Figures 8 and 9 show in top-plan view a portion of a semiconductor chip comprising two alternative embodiments of vertical MOS transistors, with gate electrodes in form of serpentine;
Figure 10 shows a first step of a process according to the invention for the integration in a same semiconductor chip of at least two horizontal MOS transistors with different threshold voltages;
Figure 11 is a top-plan view of two portions of a semiconductor chip wherein there are respectively integrated two horizontal MOS transistors with different threshold voltages;
Figures 12 and 13 show two further steps of the process according to the invention for the integration of the two horizontal MOS transistors with different threshold voltages;
Figure 14 shows surface doping profiles along sections XIV-XIV and XIV'-XIV' in Figure 11.

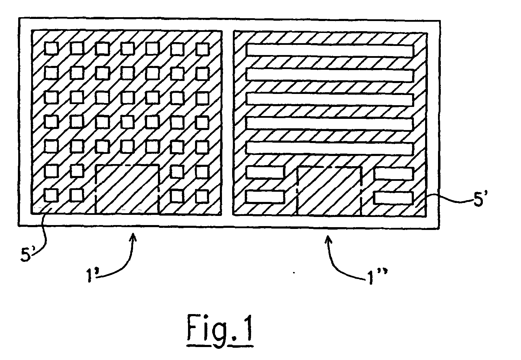

Figure 1 shows, in top-plan view, a semiconductor chip wherein two vertical MOS transistors 1', 1" are integrated having different threshold voltages. Transistors of this type are generally formed by a plurality of polygonal elementary cells, both square and rectangular, or alternatively by a plurality of stripes. In the shown example, transistor 1' is formed by square cells, while transistor 1'' is formed by stripes.

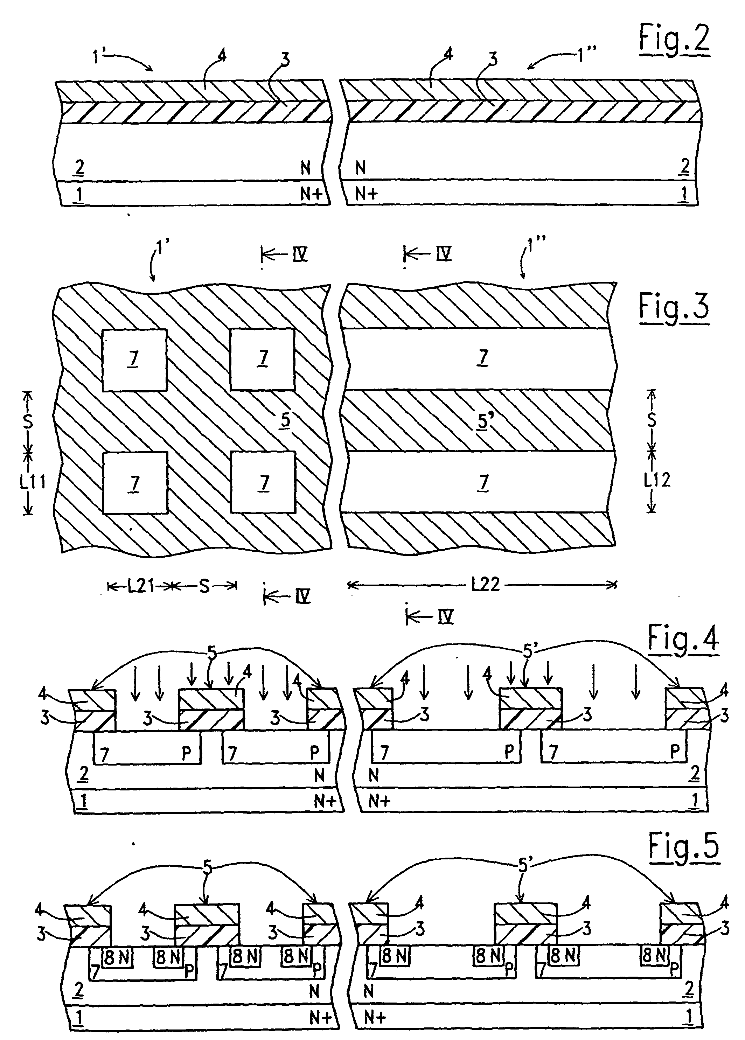

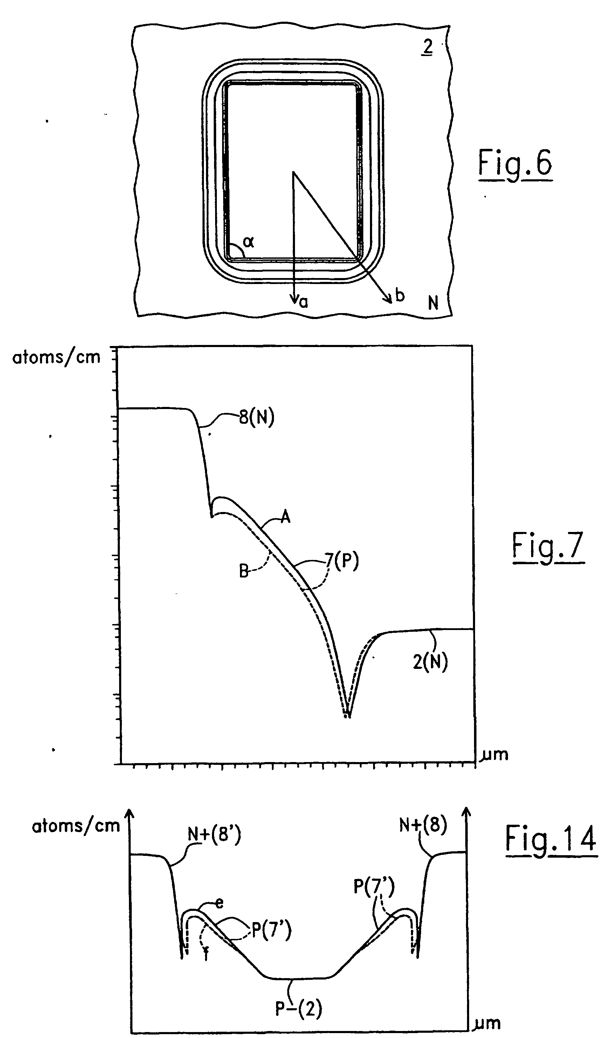

With reference to Figures 2 to 5, there are shown the main steps of a process according to the present invention for the integration in a same semiconductor chip of two vertical MOS transistors with different threshold voltages. Referring to Figure 2, the process provides for epitaxial growth, on a semiconductor substrate 1 heavily doped of, e.g., the N type, of a generally lightly doped semiconductor layer 2 of the same conductivity type, forming together with substrate 1 the drain of transistors 1' and 1". A gate oxide layer 3 and a polysilicon layer 4 are subsequently formed for creating respective gate electrodes 5 and 5' of transistors 1' and 1''. These electrodes 5, 5' are defined by means of a selective removal of layers 3 and 4, so as to define in layers 3, 4 openings that are square in the case of transistor 1', in form of stripes in the case of transistor 1'', as shown in Figure 3. In a subsequent step (Figure 4), a P type dopant is selectively introduced into the drain layer 2, using the gate electrodes 5, 5' as a mask, for the formation of body regions 7 of transistors 1' and 1''. In the shown example the body regions 7 have the shape of squares and stripes, and extend under the gate electrodes 5, 5' to form the channel regions of the transistors.

Using again the gate electrodes 5, 5' as a mask, an N type dopant is selectively introduced in the body regions 7 to form source regions 8.

The steps for forming the short-circuit between the body regions and the source regions, for realizing the insulation of the gate electrodes, for opening contacts, for forming metallization lines and for finally passivating the whole chip are performed in a conventional way.

Referring now to Figure 3, wherein two portions of the chip are shown in top-plan view, said portions having substantially a same area, the dimensions of the opening in the gate electrode 5 of transistor 1' are L11, L21, with L11=L21 in the case of square openings, and the distance between two adjacent openings is S. Differently, transistor 1" which will have a higher threshold voltage, such apertures have dimensions L12, L22, with L22>>L21 and L12=L11 , while the distance between two adjacent openings is still equal to S.

According to the present invention, the threshold voltage of the MOS transistors is varied acting only on the geometry of the gate electrodes, which act as a mask for the selective introduction of the P type dopant. In fact, at the corners of the gate electrode the dopant concentration in the channel region is lower than that at the rectilinear portions of the gate electrode (MOAAMED Darwish et al., "Transient Enhanced Threshold Shift in PWRMOS Transistors", IEDM 95).

Referring to Figure 6, showing the doping profiles as lines of equal dopant concentrations in the channel region of a generic rectangular cell of a transistor, it can be noted that the dopant concentration in the channel region near the corners of the gate electrode is lower than that near the rectilinear regions. In fact, near the corners there is a portion of greater volume for the dopant diffusion. Furthermore, the more the angle α formed by the corner of the gate electrode is acute, the lower the dopant concentration in the channel region.

Referring to Figure 7, curve A in solid shows the surface dopant concentration profile in the channel region along a rectilinear portion of the gate electrode (direction a in Figure 6), while the dashed curve B shows the concentration profile in the channel region near the corner of the gate electrode (direction b in Figure 6). It appears that the peak dopant concentration in the channel region near gate electrodes comprising substantially rectilinear portions is higher than that in the channel region near the corners thereof. Thus, the peak dopant concentration depends on the geometry of the gate electrode, so that the threshold voltage of the vertical MOS transistor depends on the geometry of the gate electrode.

In each device thus exist two areas with different threshold voltages: the corners and the rectilinear regions. Being the operating threshold voltage of the device that driving voltage for which a prescribed current flows through the device, it follows that the operating threshold voltage depends on the corner density per unit area. Thus, the threshold voltage of those transistors having gate electrodes with a higher corner density per unity area is lower.

In the case of structures with generically rectangular cells (rectangular openings in the gate electrode), the corner density per unit area D is proportional to the length of the sides L_{longer}, Lₛₕₒᵣₜₑᵣ of the transistor's cells (openings in the gate electrode), and is:${\text{D = D}}_{\text{max}} \text{•} \frac{{\text{L}}_{\text{shorter}} \text{+S}}{{\text{L}}_{\text{longer}} \text{+S}} \text{,}$ where Dₘₐₓ is the maximum corn*er density per unit area corresponding to the case of square cells, with side equal to Lₛₕₒᵣₜₑᵣ and spacing between cells equal to S.

Thus, the gate electrode of transistor 1' has, in the shown example, a corner density per unit area of:${\text{D = D}}_{\text{max}} \text{•} \frac{\text{L11+S}}{\text{L21+S}} {\text{= D}}_{\text{max}}$ while the gate electrode of transistor 1'' with a stripe layout (which can be considered rectangular cells with L_{longer} >> Lₛₕₒᵣₜₑᵣ) has a corner density per unit area of:${\text{D}}_{\text{2}} {\text{= D}}_{\text{max}} \text{•} \frac{\text{L22+S}}{\text{L12+S}} {\text{<< D}}_{\text{max}}$

Thus, being L12>>L11, D₂<D₁. For this reason, since transistor 1' has a higher corner density, it will conduct the prescribed current at a lower voltage applied to the gate electrode.

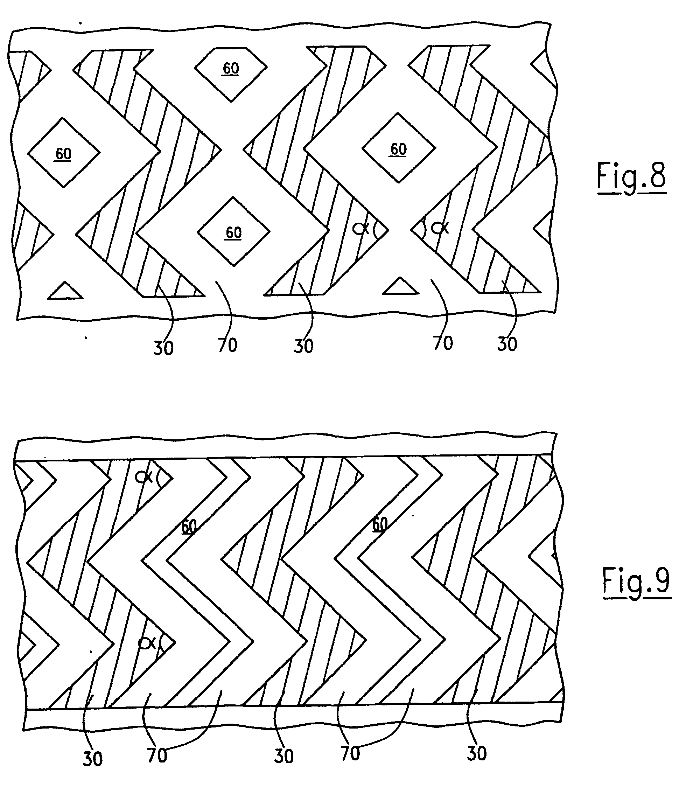

Further examples of layouts of vertical MOS transistors, wherein the gate electrodes have a stripe layout, are shown in Figures 8 and 9. In these embodiments the gate electrodes 30 of the transistors are stripes of constant width, but have a serpentine geometry.

In the embodiment of Figure 8 the body regions 60 take a rhomboidal shape, while in the embodiment of Figure 9 the body regions 60 have a serpentine geometry.

Also in these embodiments, source regions 70 are formed inside the body regions 60 so as to leave at least a central portion of the body regions for the contact of short-circuit to the source regions by means of a metallization layer.

These embodiments allows to obtain extremely high corner densities per unit area, with the further advantage of varying continuously the angle α of the corners of the gate electrodes of the transistors integrated in the same chip. The angle α can be varied from a maximum of 180°, for which the gate electrode becomes a stripe substantially free of corners, to a minimum determined by optical resolution of the photolithographic equipment employed, to achieve the maximum corner density per unit area.

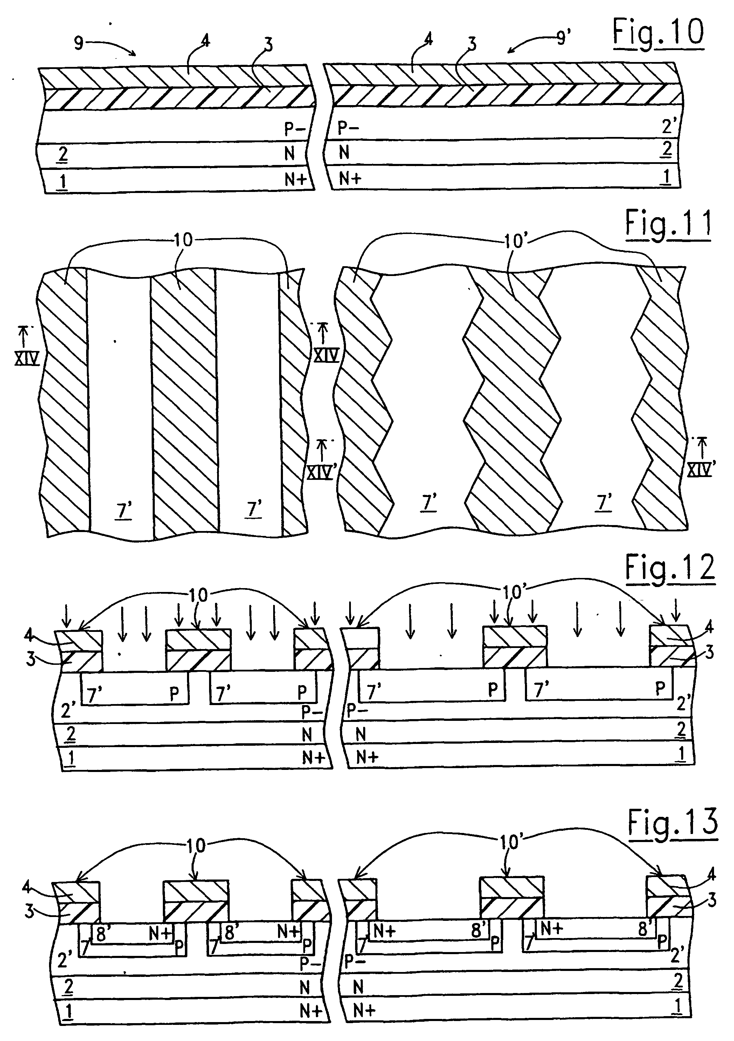

Figures 10 to 13 show steps of a process according to the invention for the integration in a same chip of two horizontal MOS transistors with different threshold voltages. In the shown example, reference is made in particular to the process previously described for the integration in the same chip of two vertical MOS transistors with different threshold voltages. The shown embodiment provides for epitaxially growing, on a heavily doped semiconductor substrate 1 of, e.g., N type, a lightly doped semiconductor layer 2 of the same conductivity type. The, a lightly doped P- semiconductor layer 2' is formed, constituting the substrate of horizontal MOS transistors 9', 9''. An oxide layer 3 and a polysilicon layer 4 are then formed for creating the gate electrodes 10, 10'. The electrodes 10, 10' are defined by means of a selective removal of layers 3, 4. In a subsequent step a P type dopant is selectively introduced in the substrate layer 2' using the gate electrodes 10, 10' as a mask, for the creation of P type regions 7' extending under the gate electrodes 10, 10'.

Using again the gate electrodes 10 as a mask, an N type dopant is selectively introduced in the P type regions 7' for creating N+ source and drain regions 8'.

The steps for the isolation of the gate electrode, for the opening of contacts, for the formation of metallization lines and for the final passivation of the whole chip are performed in a conventional way.

Advantageously, when the process according to the invention is used to integrate in the same chip both vertical and horizontal MOS transistors, the implant for the formation of the P type regions 7' in the P- well 2' of the horizontal MOS transistors is simultaneous with the formation of the body regions 7 of the vertical MOS transistors.

In Figure 14 the solid curve shows the dopant concentration profile along the channel region near a rectilinear gate electrode 10, while the dashed curve f shows the dopant concentration profile along the channel region near a corner of the gate electrode.

The process according to the invention can be advantageously applied to horizontal transistors because, changing the density and the angle of aperture of the corners of the gate electrode it is possible to obtain transistors with different threshold voltages without additional process steps.

## Claims

1. Process for integrating in a same MOS technology devices with different threshold voltages, comprising the steps of:
a) simultaneously forming on a semiconductor material layer (2,2') of at least two gate electrodes (5,5';10,10') for at least two MOS devices, said gate electrodes comprising substantially rectilinear portions and corners, each gate electrode having a respective corner density per unit area;
b) selectively introducing in the semiconductor material layer a dopant for the simultaneous formation of respective channel regions (7;7') for said at least two MOS devices, said channel regions extending under the respective gate electrode, said selective introduction using as a mask the respective gate electrodes so that said channel regions have, at the corners of the respective gate electrode, a dopant concentration lower than that at the substantially rectilinear portions, and said two MOS devices consequently have respective threshold voltages that depend on the corner density per unit area and on the aperture angles of the corners of the respective gate electrodes, the step b) beine performed subsequently to the step a).

2. Process according to claim 1, **characterized in that** said selective introduction of dopant comprises a step of dopant implantation performed using as a mask the gate electrodes, and a subsequent step of diffusion of the dopant.

3. Process according to claim 2, **characterized in that** said MOS technology power devices are vertical MOS transistors.

4. Process according to claim 2, **characterized in that** said MOS technology power devices are horizontal MOS transistors.

5. Process according to claim 2, **characterized in that** said MOS technology devices integrated in the same semiconductor chip are vertical and horizontal MOS transistors.

## Patentansprüche

1. Verfahren zum Integrieren von Vorrichtungen mit verschiedenen Schwellenspannungen in einer MOS-Technologie mit den Schritten:
a) gleichzeitiges Bilden von zumindest zwei Gateelektroden (5, 5'; 10, 10') für zumindest zwei MOS-Vorrichtungen auf einer Halbleitermaterialschicht (2, 2'), wobei die Gateelektroden im Wesentlichen geradlinige Abschnitte und Ecken aufweisen und jede Gateelektrode jeweils eine Eckendichte pro Flächeneinheit aufweist,
b) selektives Einführen eines Dotierstoffs in die Halbleitermaterialschicht zum gleichzeitigen Bilden von jeweiligen Kanalbereichen (7; 7') für die zumindest zwei MOS-Vorrichtungen, wobei diese Kanalbereiche sich unter den jeweiligen Gateelektroden erstrecken und das selektive Einführen die jeweiligen Gateelektroden als Maske verwendet, so dass die Kanalbereiche an den Ecken der jeweiligen Gateelektrode eine Dotierungskonzentration aufweisen, die geringer ist als die an den im Wesentlichen geradlinigen Abschnitten, und die zwei MOS-Vorrichtungen demzufolge jeweils Schwellenspannungen aufweisen, die von der Eckendichte pro Flächeneinheit und von den Öffnungswinkeln der Ecken der jeweiligen Gateelektroden abhängen,
wobei der Schritt b) nachfolgend auf den Schritt a) ausgeführt wird.

2. Verfahren nach Anspruch 1, **dadurch gekennzeichnet, dass** das selektive Einführen des Dotierstoffs einen Schritt der Dotierstoffimplantation enthält, der Unter Verwendung der Gateelektroden als Maske durchgeführt wird, sowie einen nachfolgenden Schritt des Diffundierens des Dotierstoffs.

3. Verfahren nach Anspruch 2, **dadurch gekennzeichnet, dass** die MOS-Technologie-Leistungsvorrichtungen vertikale MOS-Transistoren sind.

4. Verfahren nach Anspruch 2, **dadurch gekennzeichnet, dass** die MOS-Technologie-Leistungsvorrichtungen horizontale MOS-Transistoren sind.

5. Verfahren nach Anspruch 2, **dadurch gekennzeichnet, dass** die in demselben Halbleiterchip integrierten MOS-Technologie-Vorrichtungen vertikale und horizontale MOS-Transistoren sind.

## Revendications

1. Procédé permettant d'intégrer, dans une même puce semiconductrice, des dispositifs MOS ayant des tensions de seuil différentes, le procédé comprenant les opérations suivantes :
a) former simultanément sur une couche de matériau semiconducteur (2,2') au moins deux électrodes de grille (5,5';10,10') relatives à au moins deux dispositifs MOS, lesdites électrodes de grille comprenant des parties sensiblement rectilignes et des coudes, chaque électrode de grille ayant une densité de coudes respective par unité d'aire ;
b) introduire sélectivement dans la couche de matériau semiconducteur un agent dopant relatif à la formation simultanée de régions de canal respectives (7;7') pour lesdits deux ou plus de deux dispositifs MOS, lesdites régions de canal s'étendant sous l'électrode de grille respective, ladite introduction sélective utilisant comme masque les électrodes de grille respectives de façon que lesdites régions de canal aient, au niveau des coudes de l'électrode de grille respective, une concentration en agent dopant qui soit inférieure à celle existant au niveau des parties sensiblement rectilignes, et lesdits deux dispositifs MOS ont, par conséquent, des tensions de seuil respectives qui dépendent de la densité de coudes par unité d'aire et des angles d'ouverture des coudes des électrodes de grille respectives, l'opération b) étant effectuée à la suite de l'opération a).

2. Procédé selon la revendication 1, **caractérisé en ce que** ladite introduction sélective d'agent dopant comprend une opération d'implantation d'agent dopant qui s'effectue en utilisant, comme masque, les électrodes de grille et une opération, effectuée consécutivement de diffusion de l'agent dopant.

3. Procédé selon la revendication 2, **caractérisé en ce que** lesdits dispositifs de puissance en technique MOS sont des transistors MOS verticaux.

4. Procédé selon la revendication 2, **caractérisé en ce que** lesdits dispositifs de puissance en technique MOS sont des transistors MOS horizontaux.

5. Procédé selon la revendication 2, **caractérisé en ce que** lesdits dispositifs de puissance en technique MOS intégrés dans la même puce semiconductrice sont des transistors MOS verticaux et horizontaux.
